# EUROPEAN PATENT APPLICATION

(11) **EP 4 411 821 A1**
(43) Date of publication of application: **07.08.2024**
(21) Application number: 22923340.8
(22) Date of filing: 18.10.2022
(51) Int. Cl.: H01L 29/06, H01L 21/04

(54) **TERMINAL STRUCTURE, MANUFACTURING METHOD AND POWER DEVICE**

(30) Priority: 25.01.2022 CN 202210085312; 25.01.2022 CN 202220207437 U
(71) Applicant: Hubei Jiufengshan Laboratory, Wuhan, Hubei 430070 (CN)
(72) Inventor: YUAN, Jun, Wuhan, Hubei 430070 (CN)
(74) Representative: KASTEL Patentanwälte PartG mbB
(86) International application number: PCT/CN2022/125791
(87) International publication number: WO 2023/142540

(57) **Abstract**

Provided in the present application are a terminal structure, a manufacturing method and a power device. The terminal structure comprises: a first epitaxial layer; a buried layer, which is located on a side of the first epitaxial layer; a first doped area, which penetrates the buried layer, wherein the doping type of the first doped area is opposite to that of the buried layer; a second epitaxial layer, which is located on a side of the buried layer that faces away from the first epitaxial layer, wherein a main junction expansion area and a field limiting ring are provided in the second epitaxial layer; and an oxidation layer, which is located on a side of the second epitaxial layer that faces away from the buried layer, wherein the doping types of both the second epitaxial layer and the first epitaxial layer are opposite to that of the buried layer; and in a first direction, the field limiting ring is located between the main junction expansion area and the first doped area, and the first direction is perpendicular to a direction pointing to the second epitaxial layer from the first epitaxial layer. By means of the terminal structure, the manufacturing method and the power device provided in the technical solution of the present invention, the voltage endurance capability of the terminal structure is improved, and the reliability and stability of the power device are also improved.

## Description

The present application claims priority to Chinese Patent Application No. 202210085312.1, titled "TERMINATION STRUCTURE, METHOD FOR MANUFACTURING THE SAME, AND POWER DEVICE", filed on January 25, 2022 with the China National Intellectual Property Administration, which is incorporated herein by reference in its entirety. The present application claims priority to Chinese Patent Application No. 202220207437.2, titled "TERMINATION STRUCTURE AND POWER DEVICE", filed on January 25, 2022 with the China National Intellectual Property Administration, which is incorporated herein by reference in its entirety.

### FIELD

The present disclosure relates to the field of semiconductor, and in particular to a termination structure, a method for manufacturing the same, and a power device.

### BACKGROUND

Silicon carbide (SiC) is a wide bandgap semiconductor material that has developed rapidly in the recent decade. The SiC is advantageous in a wide band gap, high thermal conductivity, high carrier saturation mobility, high power density, and the like in comparison with other semiconductor materials. Since the 1990s, SiC power devices have been widely applied in, for example, switching power supplies, high-frequency heating, automotive electronics, and power amplifiers.

When designing and manufacturing conventional SiC power devices especially high-voltage power devices, a termination structure of the power device is sensitive to doping concentration and interface charges in junction termination extension, is low in a breakdown voltage, is weak in voltage tolerance, and thus reduces reliability and stability of the power device. Therefore, how to provide a reliable and effective termination structure for power devices has become an urgent problem for those skilled in the art.

### SUMMARY

At least in view of the above, a termination structure, a method for manufacturing the termination structure, and a power device are provided according to embodiments of the present disclosure. The termination structure has good voltage tolerance, which improves reliability and stability of the power device.

Following technical solutions are provided according to embodiments of the present disclosure.

In a first aspect, a termination structure is provided according to an embodiment of the present disclosure. The termination structure comprises: a first epitaxial layer; a buried layer disposed at a side of the first epitaxial layer; a first doped portion running through the buried layer, where polarity of dopants in the first doped portion is opposite to polarity of dopants in the buried layer; a second epitaxial layer disposed at a side of the buried layer away from the first epitaxial layer, where the second epitaxial layer comprises a main-junction extension portion and one or more field limiting rings; and an oxide layer disposed at a side of the second epitaxial layer away from the buried layer, where polarity of dopants in the second epitaxial layer and polarity of dopants in the first epitaxial layer each is opposite to the polarity of the dopants in the buried layer, and the one or more field limiting rings is disposed between the main-junction extension portion and the first doped portion along a first direction which is perpendicular to a direction pointing from the first epitaxial layer toward the second epitaxial layer.

In an embodiment, a first groove is located on a surface of the oxide layer away from the buried layer, the first groove runs into the second epitaxial layer, and the first groove serves as a window for ion implantation through which the first doped portion is formed.

In an embodiment, the termination structure further comprises a first protective layer disposed at a bottom of the first groove, and the first protective layer is separated from the first doped portion by a distance.

In an embodiment, the termination structure further comprises one or more second doped portions and one or more third doped portions, running through the buried layer, where: the one or more second doped portions and the one or more third doped portions are disposed between the one or more field limiting rings and the first doped portion; polarity of dopants in each of the one or more second doped portions is opposite to the polarity of the dopants in the buried layer; polarity of dopants in the each of the one or more third doped portions is identical to the polarity of the dopants in the buried layer; and concentration of the dopants in each of the one or more third doped portions is greater than concentration of the dopants in the buried layer.

In an embodiment, one or more second grooves are located at a surface of the oxide layer away from the buried layer, the one or more second grooves runs into the second epitaxial layer, and each of the one or more second grooves serves as a window for ion implantation through which a second doped portion of the one or more second doped portions and a third doped portion of the one or more third doped portions are formed.

In an embodiment, the termination structure further comprises a second protective layer disposed at a bottom of each of the one or more second grooves, the second doped portion is separated from the second protective layer by a distance, and the third doped portions is in contact with the second protective layer.

In an embodiment, a quantity of the one or more third doped portions is greater than one, and the one or more third doped portions are arranged at intervals along the first direction.

In an embodiment, a distance between every adjacent ones of the one or more second grooves is identical, and respective widths of the one or more second grooves decrease gradually along a direction pointing from the main-junction extension portion toward the one or more field limiting rings. Alternatively, a width of each of the one or more second grooves is identical, and distances between adjacent ones of the one or more second grooves increase gradually along a direction pointing from the main-junction extension portion toward the one or more field limiting rings.

In an embodiment, a quantity of the one or more field limiting rings is greater than one, and the one or more field limiting rings are arranged at intervals along the first direction.

In an embodiment, a distance between every adjacent ones of the one or more field limiting rings is identical, and respective widths of the one or more field limiting rings decrease gradually along a direction pointing from the main-junction extension portion toward the one or more field limiting rings. Alternatively, a width of each of the one or more field limiting rings is identical, and distances between adjacent ones of the one or more field limiting rings increase gradually along a direction pointing from the main-junction extension portion toward the one or more field limiting rings.

In a second aspect, a power device is provided according to an embodiment of the present disclosure. The power device comprises: any foregoing termination structure; and a cell portion disposed at a side of the main-junction extension portion away from the one or more field limiting rings.

In a third aspect, a method for manufacturing a termination structure is provided is provided according to an embodiment of the present disclosure. The method comprises: providing an epitaxial wafer, where the epitaxial wafer comprises a first epitaxial layer, a buried layer disposed at a side of the first epitaxial layer, and a second epitaxial layer disposed at a side of the buried layer away from the first epitaxial layer, and polarity of dopants in the second epitaxial layer and polarity of dopants in the first epitaxial layer each is opposite to polarity of dopants in the buried layer; forming an oxide layer on a surface of the second epitaxial layer away from the buried layer; forming a main-junction extension portion and one or more field limiting rings in the second epitaxial layer; and forming a first doped portion running the buried layer, where polarity of dopants in the first doped portion is opposite to the polarity of the dopants in the buried layer, and the one or more field limiting rings are located between the main-junction extension portion and the first doped portion along a first direction which is perpendicular to a direction pointing from the first epitaxial layer toward the second epitaxial layer.

In an embodiment, forming the first doped portion comprises: forming a first groove on a surface of the oxide layer away from the buried layer; and implanting ions via the first groove to form the first doped portion.

In an embodiment, the method further comprises: forming one or more second grooves when forming the first groove; implanting, when forming the first doped portion, the ions via the one or more second grooves to form one or more second doped portions running through the buried layer; and implanting, after forming the one or more second doped portions, other ions via the one or more second grooves to form one or more third doped portions running through the buried layer, where the one or more second doped portions and the one or more third doped portions are located between the one or more field limiting rings and the first doped portion.

Thereby, the termination structure, the method for manufacturing the termination structure, and the power device are provided in technical solutions of the present disclosure. Due to the buried layer, a strong electric field in the main-junction extension portion is smoothly distributed throughout an intermediate region, namely a region of the field limiting ring(s) or a region of the field limiting ring(s) and the third doped portion(s), of the termination structure. Thereby, multiple components coordinate to share energy causing avalanche breakdown, which improve an avalanche threshold of the termination structure. That is, voltage tolerance of the termination structure is improved, and hence reliability and stability of the power device are improved.

### BRIEF DESCRIPTION OF THE DRAWINGS

Hereinafter drawings to be applied in embodiments of the present disclosure or in conventional technology are briefly described, in order to clarify illustration of technical solutions according to embodiments of the present disclosure or in conventional technology. Apparently, the drawings in the following descriptions are only some embodiments of the present disclosure, and other drawings may be obtained by those skilled in the art based on the provided drawings without exerting creative efforts.

Structures, scales, dimensions, and the like as shown in the drawings of the specification are drawn in coordination with contents disclosed in the specification, and are intended for being understood and apprehended by those skilled in the art rather than putting a limitation on conditions of implementing embodiments of the present disclosure, and therefore have no actual/real significance in techniques. Any structural modification, change in proportional relationship, or adjustment in dimensions, when not affecting an effect or a purpose of embodiments of the present disclosure, shall fall within the scope covered by technical content disclosed herein.
Figure 1 is a cross-sectional view of a conventional junction termination extension structure according to an embodiment of the present disclosure.
Figure 2 is a cross-sectional view of a conventional structure of field limiting rings according to an embodiment of the present disclosure.
Figure 3 is a cross-sectional view of a termination structure according to an embodiment of the present disclosure.
Figure 4 is a cross-sectional view of a termination structure according to another embodiment of the present disclosure.
Figure 5 is a top view of a power device according to an embodiment of the present disclosure.
Figure 6 to Figure 11 are cross-sectional views showing a process of a method for manufacturing a termination structure according to an embodiment of the present disclosure.
Figure 12 to Figure 16 are cross-sectional views showing a process of a method for manufacturing a termination structure according to another embodiment of the present disclosure.

### DETAILED DESCRIPTION OF EMBODIMENTS

The embodiments of the present disclosure are described below clearly and completely in conjunction with the drawings of the embodiments of the present disclosure. Apparently, the embodiments described below are only some embodiments of the present disclosure, rather than all the embodiments. Any other embodiments obtained by those skilled in the art based on the embodiments in the present disclosure without any creative effort fall within the protection scope of the present disclosure.

When designing and manufacturing conventional power devices especially high-voltage power devices made of silicon carbide (SiC) or the like, excellent termination structures, such as field plates (FPs), field limiting rings (FLRs), and junction termination extension (JTE), are desirable for weakening an electric field at an edge of a junction and improving actual voltage tolerance of the devices. The FLRs and the JTE have been widely applied to conventional power devices made of SiC or the like.

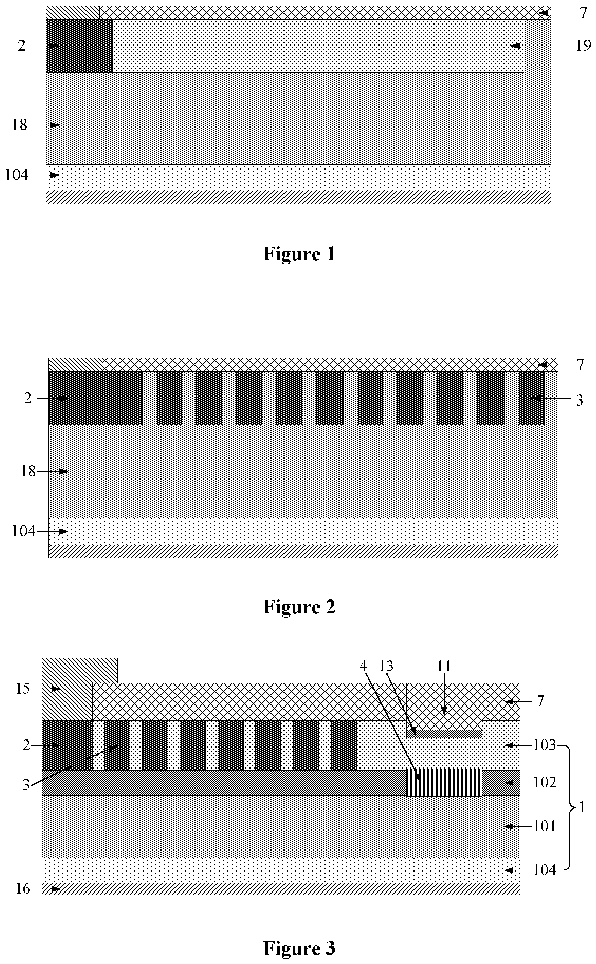

Reference is made to Figure 1, which is a cross-sectional view of a conventional JTE structure according to an embodiment of the present disclosure. The JTE structure comprises a substrate 104, an epitaxial layer 18, an oxide layer 7, a main-junction extension portion 2, and a JTE portion 19.

The epitaxial layer 18 is located at a side of the substrate 104. The oxide layer 7 is located at a side of the epitaxial layer 18 away from the substrate 104. The main-junction extension portion 2 is located in the epitaxial layer 18. The JTE portion 19 is located in the epitaxial layer 18 and at a side of the main-junction extension portion 2.

In such JTE structure, doping concentration of the JTE portion 19 serves as a figure of merit, and a breakdown voltage of the JTE structure is sensitive to the doping concentration of the JTE portion 19. Hence, the JTE structure has a small design window. Moreover, the JTE structure is quite sensitive to charges on its surface, and hence instability of an interface and charges in the oxide layer 7 can easily affect distribution of an electric field at a surface of the device, which reduces a breakdown voltage and reliability of the device. In addition, manufacture of such termination structure is too complex to facilitate large-scale production.

Reference is made to Figure 2, which is a cross-sectional view of a conventional structure of FLRs according to an embodiment of the present disclosure. The FLR structure comprises a substrate 104, an epitaxial layer 18, an oxide layer 7, a main-junction extension portion 2, and a field limiting ring 3.

The epitaxial layer 18 is located at a side of the substrate 104. The oxide layer 7 is located at a side of the epitaxial layer 18 away from the substrate 104. The main-junction extension portion 2 is located in the epitaxial layer 18. The FLRs 3 are also located in the epitaxial layer 18 and at a side of the main-junction extension portion 2.

In such FLR structure, since an electric filed at a surface of a device made of SiC or the like is strong, a large quantity of FLRs needs to be configured for weakening a peak value of such electric field and thus improving voltage tolerance. Distribution of the electric field may be affected by various factors, such as a quantity of rings, widths of the rings, and a distance between the rings. The FLR structure would occupy a large area on a chip due to the multiple FLRs 3, which may hinder an increase of a current. Moreover, the FLR structure is also quite sensitive to charges on its surface, and hence instability of an interface and charges in the oxide layer 7 can easily affect distribution of an electric field at a surface of the device, which reduces a breakdown voltage and reliability of the device.

In order to address at least the above issues, a termination structure, a method for manufacturing the termination structure, and a power device are provided according to embodiments of the present disclosure. Voltage tolerance of the termination structure is excellent, and hence reliability and stability of the power device are improved.

Hereinafter the present disclosure would be further described in detail in conjunction with the drawings and embodiments to clarify and elucidate objectives, features and advantages of the present disclosure.

Reference is made to Figure 3, which is a cross-sectional view of a termination structure according to an embodiment of the present disclosure. The termination structure comprises a first epitaxial layer 101, a buried layer 102, a first doped portion 4, a second epitaxial layer 103, a main-junction extension portion 2, FLR(s) 3, and an oxide layer 7.

The buried layer 102 is located at a side of the first epitaxial layer 101. The first doped portion 4 runs through the buried layer 102. Polarity of dopants in the first doped portion 4 is opposite to polarity of dopants in the buried layer 102. The second epitaxial layer 103 is located at a side of the buried layer 102 away from the first epitaxial layer 101. The main-junction extension portion 2 and the FLR(s) 3 are located in the second epitaxial layer 103. The oxide layer 7 is located at a side of the second epitaxial layer 103 away from the buried layer 102.

Polarity of dopants in the second epitaxial layer 103 and polarity of dopants in the first epitaxial layer 101 is opposite to the polarity of the dopants in the buried layer 102. Along the first direction, the FLR(s) 3 is located between the main-junction extension portion 2 and the first doped portion 4. The first direction is perpendicular to a direction pointing from the first epitaxial layer 101 toward the second epitaxial layer 103.

In addition, polarity of dopants in the main-junction extension portion 2 is identical to polarity of dopants in the FLR(s) 3, and they are both opposite to the polarity of the dopants in the second epitaxial layer 103. That is, the main-junction extension portion 2, the FLR 3, and the buried layer 102 have the same polarity of dopants. Moreover, the main-junction extension portion 2 and the FLR(s) 3 may all be heavily doped. Generally, the concentration of the dopants in the main-junction extension portion 2 and in the FLR(s) 3 is greater than that of the dopants in the buried layer 102. For example, it is assumed that the first epitaxial layer 101 and the second epitaxial layer 103 are n-doped. In such case, the buried layer 102 is p-doped, the first doped portion 4 is n-doped, and concentration of the n-type dopants in the first doped portion 4 is greater than the p-type dopants in the buried layer 102. In addition, the main-junction extension portion 2 and the FLR 3 are both heavily p-doped. Here the main-junction extension portion is configured to provide smooth transition of electric field from a cell portion of a power device to the termination structure of the power device.

Herein two or more objects having the same polarity of dopants indicates that they are both n-doped or both p-doped, while they may be identical or different in concentration of the dopants. Correspondingly, two or more objects having different polarity of dopants indicates that at least one object is n-doped while at least another object is p-doped, while they may be identical or different in concentration of the dopants.

In an embodiment, a material of each of the first epitaxial layer 101, the buried layer 102, and the second epitaxial layer 103 may comprise one or more of: Si, SiC, and Ga₂O₃.

Herein doping refers to normal doping by default, unless its concentration is otherwise limited. Concentration of the normal doping ranges between that of light doping and that of heavy doping. For example, concentration of n-doping ranges between concentration of light n-doping and concentration of heavy n-doping. The above is applied to following description and would not be repeated.

In the above termination structure, a leakage channel along the buried layer 102 may be introduced formed and may affect reliability of the device. Hence, the first doped portion 4 is provided for cutting off the electric field in the termination structure, and thereby prevents a leakage current from affecting other components. In addition, the first doped portion 4 is capable to prevent various mechanisms from forming an inversion layer on the surface of the device and reduce an impact of surface contamination on a breakdown voltage. Hence, reliability of the device is improved. In addition, the buried layer 102 is capable to distribute the strong electric field smoothly from the main-junction extension portion 2 to the FLR(s) 3. That is, the FLR(s) 3 serves as a voltage divider to improve voltage tolerance of the termination structure. Thereby, reliability and stability of the device are improved.

In an embodiment, a first groove 11 is arranged on a surface the oxide layer 7 away from the buried layer 102. The first groove 11 runs into the second epitaxial layer 103 and is configured to provide a window for ion implantation through which the first doped portion 4 is formed. A depth of the first groove 11 may be configured on requirement. A bottom of the first groove 11 may be located in the second epitaxial layer 103, may be located in the oxide layer 7, or may located at an interface between the oxide layer 7 and the second epitaxial layer 103. The above cases all fall within the protection scope of the present disclosure. In practice, the first groove 11 may be fabricated through modifying an existing process without adding a new process. In addition, a patterned photoresist may serve as the window for the ion implantation when forming the first doped portion 4, and the first groove 11 may not be formed in such case.

In an embodiment, the termination structure comprises a first protective layer 13. The first protective layer 13 is located at the bottom of the first groove 11, and the first protective layer 13 is separated from the first doped portion 4 by a distance. Ions may be implanted via the first groove 11 to form the first protective layer 13 at the bottom of the first groove 11. Polarity of dopants in the first protective layer 13 is opposite to the polarity of the dopants in the first doped portion 4 and is identical to the polarity of the dopants in the FLR(s) 3 and the main-junction extension portion 2. Concentration of the dopants in the first protective layer 13 is lower than that of the dopants in the FLR(s) 3 and the main-junction extension portion 2. For example, it is assumed that the FLR(s) 3 and the main-junction extension portion 2 are both heavily p-doped. In such case, the first protective layer 13 is p-doped or lightly p-doped. Generally, the first protective layer 13 is lightly p-doped. The first protective layer 13 is capable to reduce an influence of charges in the oxide layer 7 on the termination structure and reduce a possibility of surface breakdown. Thereby, reliability and stability of the device are improved.

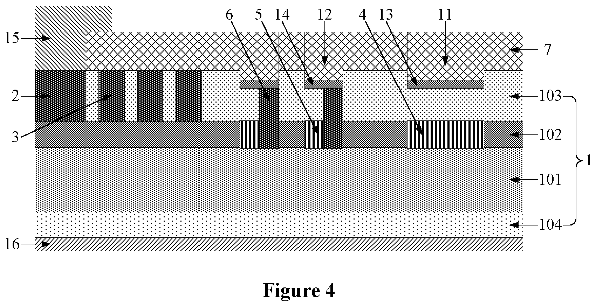

Reference is made to Figure 4, which is a cross-sectional view of a termination structure according to another embodiment of the present disclosure. On a basis of a structure as shown in Figure 3, the termination structure further comprises second doped portion(s) 5 and third doped portion(s) 6.

The second doped portion(s) 5 and the third doped portion(s) 6 run through the buried layer 102. The second doped portion(s) 5 and the third doped portion(s) 6 are located between the FLR(s) 3 and the first doped portion 4. Polarity of dopants in the second doped portion(s) 5 is opposite to the polarity of the dopants in the buried layer 102. Polarity of dopants in the third doped portion(s) 6 is identical to the polarity of the dopants in the buried layer 102, and concentration of the dopants in the third doped portion(s) 6 is greater than the concentration of the dopants in the buried layer 102. Generally, concentration of the dopants in the second doped portion(s) 5 is greater than the concentration of the dopants in the buried layer 102. For example, it is assumed that the buried layer 102 is p-doped. In such case, the second doped portion(s) 5 are heavily n-doped, and the third doped portion(s) 6 are heavily p-doped.

In the above structure, the buried layer 102 is capable to distribute the strong electric field smoothly from the main-junction extension portion 2 to an intermediate region, namely, the FLR(s) 3 and the third doped portion(s) 6, of the terminal structure. Thereby, multiple components coordinate to share energy which induces avalanche breakdown in the device, which improves an avalanche threshold of the termination structure and thus increases a breakdown voltage of the device. Voltage tolerance of the termination structure is improved, and reliability and stability of the power device are improved.

In an embodiment, second groove(s) 12 are provided on the surface of the oxide layer 7 away from the buried layer 102. The second groove(s) 12 each runs into the second extension layer 103, and is configured to provide a window for ion implantation through which the corresponding second doped portion 5 and the corresponding third doped portion 6 are formed. Similar to the first groove 11, a depth of the second groove 12 may be configured on requirement. A bottom of the second groove 12 may be located in the second extension layer 103, may be located in the oxide layer 7, or may be located at the interface between the oxide layer 7 and the second extension layer 103. All the above cases fall within the protection scope of the present disclosure. Similarly, in practice, the second groove(s) 12 may be fabricated through modifying an existing process without adding a new process. Generally, the second groove(s) 12 may be formed along with the first groove 11. In addition, a patterned photoresist may serve as the window for the ion implantation when forming the second doped portion(s) 5 or the third doped portion(s) 6, and the second groove(s) 11 may not be formed in such case.

A width of each second groove 12 may be smaller than a width of the first groove 11, which may reduce an area of the termination structure. The first groove 11 may have a large width to ensure a better effect of cutting off the electric field. Generally, the width of the first groove 11 is greater than 5µm.

In practice, the main-junction extension portion 2 is not such ideal that its edge may have a bending region due to etching, which affects the breakdown voltage of the device. The first groove 11 and the second groove(s) 12 are capable to reduce concentration of ions in the second epitaxial layer 103. Hence, the electric field in the bending region of the main-junction extension portion 2 is weakened, and the breakdown voltage is increased. In addition, utilization of the area of the termination structure can be effectively improved due to the first groove 11 and the second groove(s) 12, because an area for voltage division is reduced. Thereby, the termination structure occupies a smaller area on a chip, more devices can be manufactured within a same area of a silicon wafer, and a cost of chips is reduced. In practice, the first groove 11 and/or the second groove 12 may not be formed due to a requirement on processing or design.

In an embodiment, the first groove 11 or the second groove 12 may be rectangular, a trapezoidal, or U-shaped.

In an embodiment, the termination structure comprises a second protective layer 14 located at the bottom of the second groove 12. The second doped portion 5 is separated from the second protective layer 14 by a distance, while the third doped portion 6 is in contact with the second protective layer 14. Similar to the first protective layer 13, polarity of dopants in the second protective layer 14 is opposite to the polarity of the dopants in the second doped portion 5 and identical to the polarity of the dopants in the third doped portion 6. Concentration of dopants in the second protective layer 14 is lower than concentration of the dopants in the third doped portion 6. For example, it is assumed that the second doped portion 5 is n-doped and the third doped portion 6 is p-doped, and in such case the second protective layer 14 is lightly p-doped. The second protective layer 14 is located between the second groove 12 and the third doped portion 6 and in contact the third doped portion 6, which reduces an influence of charges in the oxide layer 7 on the third doped portion 6. Hence, surface breakdown is less likely, voltage division of the third doped portion 6 is more significant, and a breakdown voltage of the device is improved. Thereby, reliability and stability of the device are improved.

In an embodiment, the termination structure comprises multiple third doped portions 6 that are arranged at intervals along the first direction. The multiple third doped portions 6 are capable to achieve a better effect of voltage division, which reduces energy of avalanche breakdown shared by each third doped portion 6. Thereby, the breakdown voltage of the device is further improved, and voltage tolerance of the device is improved.

In a first embodiment, distances between adjacent second grooves 12 are identical, and widths of the second grooves 12 decrease gradually along a direction pointing from the main-junction extension portion 2 toward the FLR(s) 3.

In a second embodiment, widths of the second grooves 12 are identical, and distances between adjacent second grooves 12 increase gradually along the direction pointing from the main-junction extension portion 2 toward the FLR(s) 3.

Herein one second groove 12, its corresponding second doped portion 5, and its corresponding third doped portion 6 may form one groove ring. That is, in the first embodiment, distances between adjacent grooved rings are identical, and widths of the grooved rings decrease gradually along the direction pointing from the main-junction extension portion 2 toward the FLR(s) 3. In the second embodiment, widths of the grooved rings are identical, and distances between adjacent grooved rings increase gradually along the direction pointing from the main-junction extension portion 2 toward the FLR(s) 3.

In both cases, the distribution of the electric field in the termination structure is optimized, and the termination structure is less sensitive to a dose of the charges, which improves reliability and stability of the power device. In practice, one of the two configurations may be selected on requirement. In addition, the width of each groove ring and the distances between adjacent groove rings may be flexibly configured according to specifications of the device, and are not specifically limited herein.

In an embodiment, the termination comprises multiple FLRs 3 that are arranged at intervals along the first direction. The multiple FLRs 3 are capable to achieve a better effect of voltage division, which reduces energy of avalanche breakdown shared by each FLR 3. Thereby, the breakdown voltage of the device is further improved, and voltage tolerance of the device is improved.

In a first embodiment, distances between adjacent FLRs 3 are identical, and widths of the FLRs 3 decrease gradually along a direction pointing from the main-junction extension portion 2 toward the FLR(s) 3.

In a second embodiment, widths of the FLRs 3 are identical, and distances between adjacent FLRs 3 increase gradually along the direction pointing from the main-junction extension portion 2 toward the FLR(s) 3.

In both cases, the distribution of the electric field in the termination structure is optimized, and the termination structure is less sensitive to a dose of the charges, which improves reliability and stability of the power device. In practice, one of the two configurations may be selected on requirement. In addition, the width of each FLR and the distances between adjacent FLRs may be flexibly configured according to specifications of the device, and are not specifically limited herein.

Herein due to limitations of the drawings, variations of the width of the FLR 3, variations of the width of the groove ring, variations of the distance between adjacent FLRs 3, and variations of the distance between adjacent groove rings, are not depicted. The lack of these variations in the drawings does not mean that the present disclosure does not include these variations.

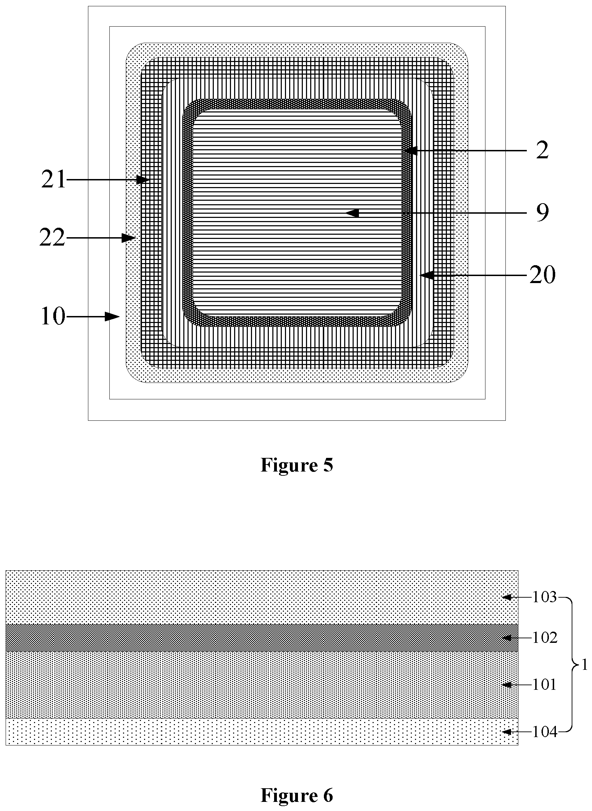

On a basis of the foregoing termination structures, a power device is further provided according to an embodiment of the present disclosure. The power device may refer to description of the foregoing termination structures. Reference is made to Figure 5, which is a top view of a power device according to an embodiment of the present disclosure. The power device comprises any foregoing termination structure and a cell portion 9. The cell portion 9 is located at a side of the main-junction extension portion 2 away from the FLR(s) 3.

As shown in Figure 5, the cell portion 9 is located at a center of the power device. The main-junction extension portion 2 surrounds the cell portion 9. A FLR portion 20 comprising the FLR(s) 3 surrounds the main-junction extension portion 2. A groove-ring portion 21 comprising the second groove(s) 12, the second doped portion(s) 5, and the third doped portion(s) 6 surrounds the FLR portion 20. An electric-field cutoff portion 22 comprising the first groove 11 and the first doped portion 4 surrounds the groove-ring portion 21. In addition, a scribe lane 10 may be located between adjacent power devices, such that a silicon wafer can be divided into single power devices.

The power device includes but is not limited to PIN, SBD, MOSFET, IGBT, or GTO. A material of a wafer of the power device includes but is not limited to silicon, silicon carbide, gallium arsenide, aluminum nitride, gallium nitride, gallium oxide, or diamond.

The power device according to embodiments of the present disclosure has high breakdown voltage, and therefore has good voltage tolerance. Hence, reliability and stability of the power device are excellent.

On a basis of the above embodiments, a method for manufacturing a termination structure is further provided according to an embodiment of the present disclosure. The method may refer to the foregoing termination structures and the foregoing power device. Reference is made to Figure 6 to Figure 11, which are cross-sectional views of a process in a method for manufacturing a termination structure according to an embodiment of the present disclosure. The method comprises following steps S101 to S106.

In step S101, an epitaxial wafer 1 is provided. As shown in Figure 6, the epitaxial sheet 1 comprises a first epitaxial layer 101, a buried layer 102, and a second epitaxial layer 103. The buried layer 102 is located at a side of the first epitaxial layer 101. The second epitaxial layer 103 is located at a side of the buried layer 102 away from the first epitaxial layer 101. Polarity of dopants in the second epitaxial layer 103 and polarity of dopants in the first epitaxial layer 101 are opposite to polarity of dopants in the buried layer 102. For example, it is assumed that the buried layer 102 is p-doped. In such case, the first epitaxial layer 101 and the second epitaxial layer 103 are both n-doped.

The epitaxial wafer 1 may further comprise a substrate 104 located at a side of the first epitaxial layer 101 away from the buried layer 102. The substrate is configured to support the films and improve performances of the films. In an embodiment, the substrate 104 and the first epitaxial layer 101 are identical in the polarity of the dopants. The epitaxial layer may be directly obtained through customized purchases, or may be fabricated through deposition.

In step S102, an oxide layer 7 is formed on a surface of the second epitaxial layer 103 away from the buried layer 102. The oxide layer 7 is configured to provide protection and isolation against vapor. Particularly, when the oxide layer 7 is subject to ion bombardment during ion implantation, the oxide layer 7 can protect the film from being damaged, and can reduce or even eliminate ion-implantation damages on the films.

A photoresist may serve as a protective layer and replaces the oxide layer 7 for reducing ion-implantation damages on the films. When manufacturing the termination structure in a SiC power device (i.e., the second epitaxial layer 103 is made of SiC), Al ions are implanted to form the main-junction extension portion 2 and FLR(s) 3. In such case, the photoresist is inadequate against the ion bombardment due to a large atomic mass of the Al ion. Hence, a film structure 8 may be provided to serve as a masking layer during implantation of the Al ions. The film structure 8 is a single-layer structure of a large thickness and made of an oxide. Alternatively, the film structure 8 is a multi-layer structure. Generally, the thickness of the single-layer structure made of oxide ranges from 100nm to 10µm.

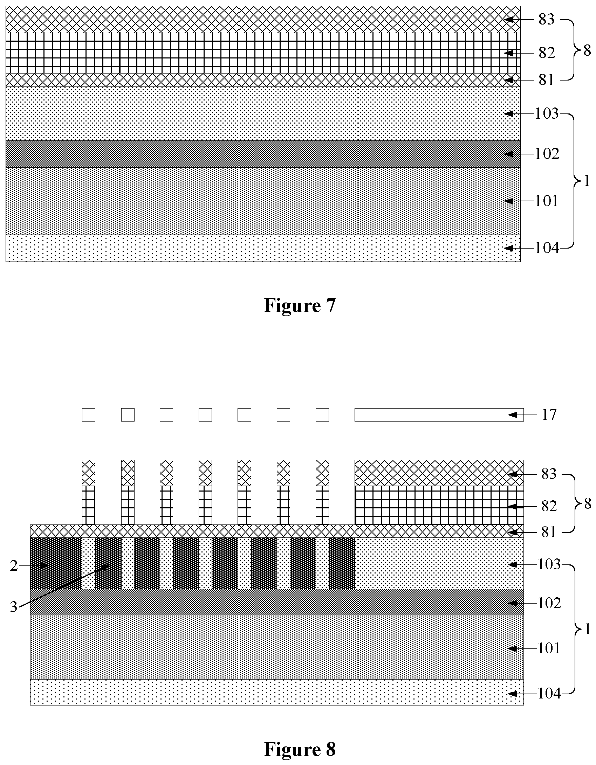

Reference is made to Figure 7. The film structure 8 may comprises three layers, namely, a first oxide layer 81, a polysilicon layer 82, and a second oxide layer 83. The first oxide layer 81 is located on a surface of the second epitaxial layer 103 away from the buried layer 102. The polysilicon layer 82 is located on a surface of the first oxide layer 81 away from the second epitaxial layer 103. The second oxide layer 83 is located on a surface of the polysilicon layer 82 away from the first oxide layer 81. A thickness of the first oxide layer ranges from 50nm to 500nm. A thickness of the polysilicon layer ranges from 100nm to 2000nm. A thickness of the second oxide layer ranges from 50nm to 500nm. Generally, the thickness of the first oxide layer is smaller than the thickness of the second oxide layer.

In step S103, a main-junction extension portion 2 and FLR(s) 3 are formed in the second epitaxial layer 103. The main-junction extension portion 2 and the FLR(s) 3 may be formed through following steps S 103.1 and S103.2.

In step S103.1, the oxide layer 7 is etched based on photolithography to form a window for ion implantation. The oxide layer is subject to photolithography, development, and the like under a pattern mask 17 to obtain the oxide layer 7 having the window(s). A window corresponding to the main-junction extension portion 2 and window(s) corresponding to the FLR(s) 3 may be formed in a same process.

In step S103.2, ions are implanted via the window to form the main-junction extension portion 2 and the FLR(s) 3.

When the ions is Al ions, the ions may be implanted via the film structure 8. As shown in Figure 8, after photolithography and development, the second oxide layer 83 is first etched using a gas, such as CF4 and CHF3, which has good selectivity on the oxide layer against the polysilicon layer 82. Then, the polysilicon layer 82 is etched using a gas, such as HBr, which has good selectivity on itself. The polysilicon layer 82 may be over-etched to some extent, and hence a thickness of the first oxide layer 81 is small. Afterwards, the thin first oxide layer 81 serves as a masking layer, and the ions are implanted to form the main-junction extension portion 2 and FLR(s) 3. Thereby, the implanted ions have a desirable distribution, which avoids a channeling effect effectively. After the ion implantation, the film structure 8 is removed through wet etching.

Herein the small thickness of the first oxide layer 81 is not depicted in the drawings. The first oxide layer 81 having the small thickness exists in the termination structure in practice.

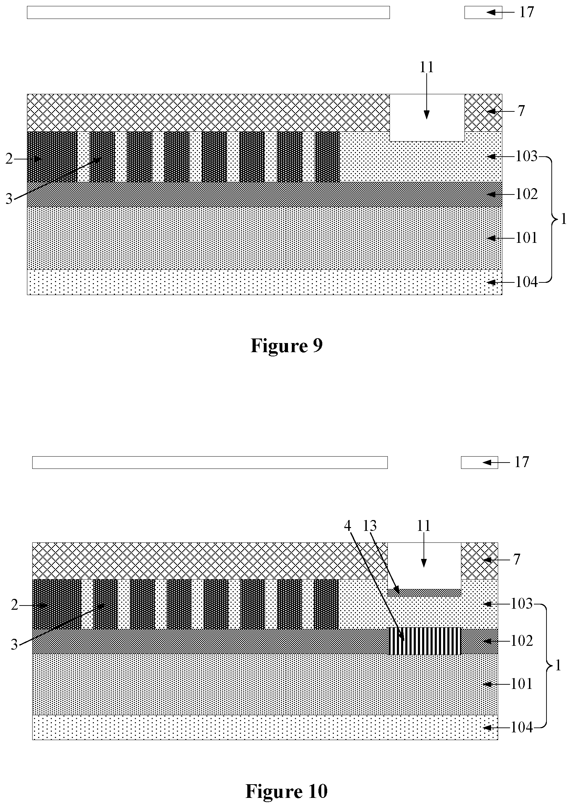

In step S104, a first doped portion 4 running through the buried layer 102 is formed, as shown in Figure 9 and Figure 10. Polarity of dopants in the first doped portion 4 is opposite to the polarity of the dopants in the buried layer 102. Along a first direction, the FLR(s) 3 is located between the main-junction extension portion 2 and the first doped portion 4. The first direction is perpendicular to a direction pointing from the first epitaxial layer 101 towards the second epitaxial layer 103.

On a basis of the above, the first doped portion 4 may be formed through following steps S104.1 and S104.2.

In step S104.1, a first groove 11 is formed on a surface of the oxide layer 7 away from the buried layer 102, as shown in Figure 9. The first groove 11 is formed through photolithography. The first groove 11 runs into the second epitaxial layer 103 and serves as a window for ion implantation through which the first doped portion 4 is formed.

In step S104.2, ions are implanted via the first groove 11 to form the first doped portion 4, as shown in Figure 10. The polarity of the dopants in the first doped portion 4 is opposite to the polarity of the dopants in the buried layer 102, and concentration of the dopants in the first doped portion 4 is greater than concentration of the dopants inthe buried layer 102. Thereby, the buried layer 102 is pinched.

Reference is made to Figure 10. The method further comprises implanting ions via the first groove 11 to form a first protective layer 13. The first protective layer 13 is located at the bottom of the first groove 11, and the first protective layer 13 is separated from the first doped portion 4 by a distance. The first protective layer 13 and the buried layer 102 are identical in polarity of the dopants, such that an influence of interface charges on the device is reduced.

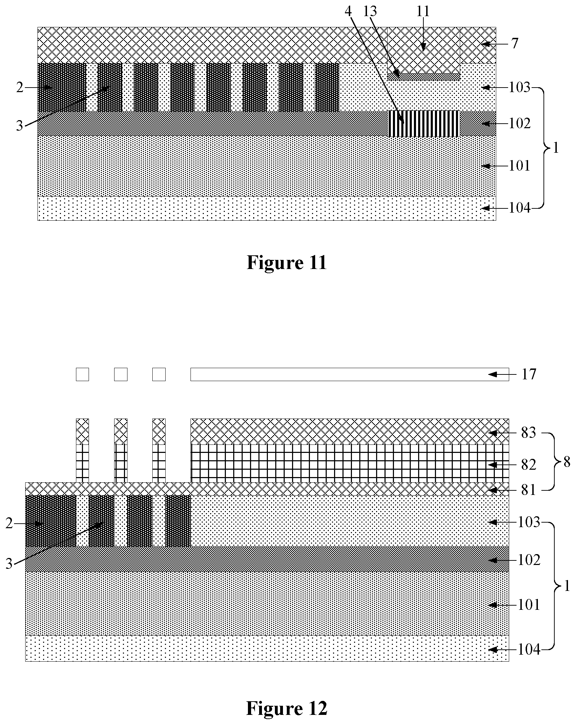

In step S105, the first groove 11 is filled with a high-x material to form a flat film, as shown in Figure 11. The high-κ material may be deposited through chemical vapor deposition (CVD) to fill the first groove 11. The high-κ material may be one of: SiO₂, SiNₓ, Al₂O₃, AlN, HfO₂, MgO, Sc₂O₃, Ga₂O₃, AlHFOₓ, HFSiON, or may be a combination among the above materials.

In step S106, a cathode 16 is formed on a surface of the substrate 104 away from the first epitaxial layer 101, and an anode 15 is formed at a side of the main-junction extension portion 2 away from the buried layer 102. The anode 15 is in contact with the main-junction extension portion 2 to form the termination structure as shown in Figure 3. Generally, the anode 15 is made of metal.

Reference is made to Figure 12 to Figure 16, which are cross-sectional views of a process of a method for manufacturing a termination structure according to another embodiment of the present disclosure. On the basis of the foregoing embodiment(s), the method may further comprise a following step S107.

Step S107 is performed prior to step S104.

In step S107, second doped portion(s) 5 and third doped portion(s) 6, each of which runs through the buried layer 102, are formed. The second doped portion(s) 5 and the third doped portion(s) 6 are located between the FLR(s) 3 and the first doped portion 4. Polarity of dopants in the second doped portion(s) 5 is opposite to the polarity of the dopants in the buried layer 102. Polarity of dopants in the third doped portion(s) 6 is identical to the polarity of the dopants in the buried layer 102, and concentration of the dopants in the third doped portion(s) 6 is greater than concentration of the dopants in the buried layer 102.

In addition, the second doped portion(s) 5 and the third doped portion(s) 6 may be formed by through following steps S107.1 to S107.3.

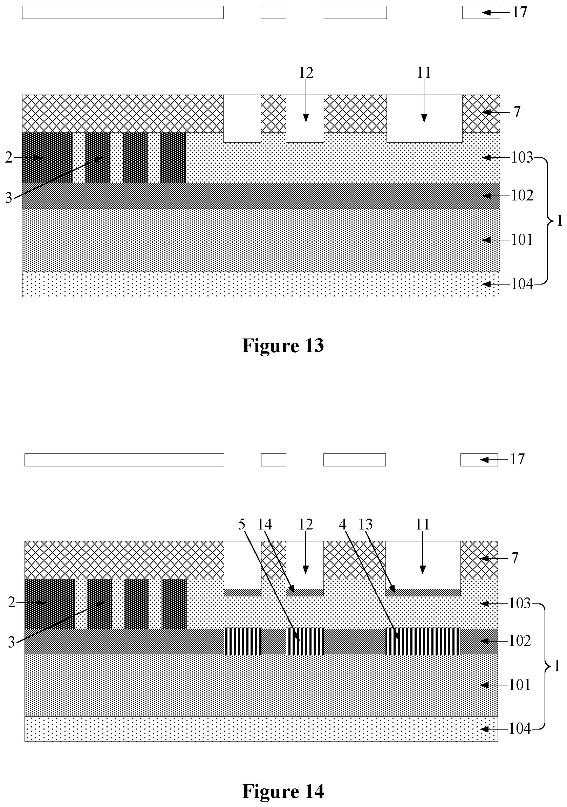

In step S107.1, second groove(s) 12 are formed on a surface of the oxide layer 7 away from the buried layer 102, as shown in Figure 13. Similarly, the second groove 12 may be formed through photolithography. The second groove 12 runs into the second epitaxial layer 103 and serves as a window for ion implantation through which the second doped portion(s) 5 and the third doped portion(s) 6 are formed. It should be noted that the first groove 11 and the second groove(s) 12 may be identical in depth. Thereby, the second groove(s) 12 may be formed along with the first groove 11.

In step S107.2, ions are implanted via the second groove(s) 12 to form second doped portion(s) 5 running through the buried layer 102, as shown in Figure 14. A polarity of dopants in the second doped portion 5 is opposite to the polarity of dopants in the buried layer 102, and doping concentration of the second doped portion 5 is greater than the doping concentration of the buried layer 102.

Reference is made to Figure 14. Ions are implanted through each second groove 12 to form a second protective layer 14. The second protective layer 14 is located at a bottom of the respective second groove 12, and the second protective layer 14 is separated from the second doped portion 5 by a distance. Polarity of dopants in the second protective layer 14 is identical to polarity of dopants in the buried layer 102, such that an influence of interface charges on the device is reduced.

The polarity of the dopants in the second doped portion(s) 5 is identical to the polarity of the dopants in the first doped portion 4, and the concentration of the dopants in the second doped portion(s) 5 and in the first doped portion 4 is greater than the concentration of the dopants in the buried layer 102. Hence, ions may be implanted via the second groove 12 when forming the first doped portion 4, so as to form the second doped portion 5 runs through the buried layer 102. Similarly, the second protective layer 14 may be formed along with the first protective layer 13.

In step S107.3, other ions are implanted via the second groove 12, after forming the second doped portion(s) 5, to form a third doped portion(s) 6 running through the buried layer 102. The second doped portion(s) 5 and the third doped portion(s) 6 are located between the FLR(s) 3 and the first doped portion 4.

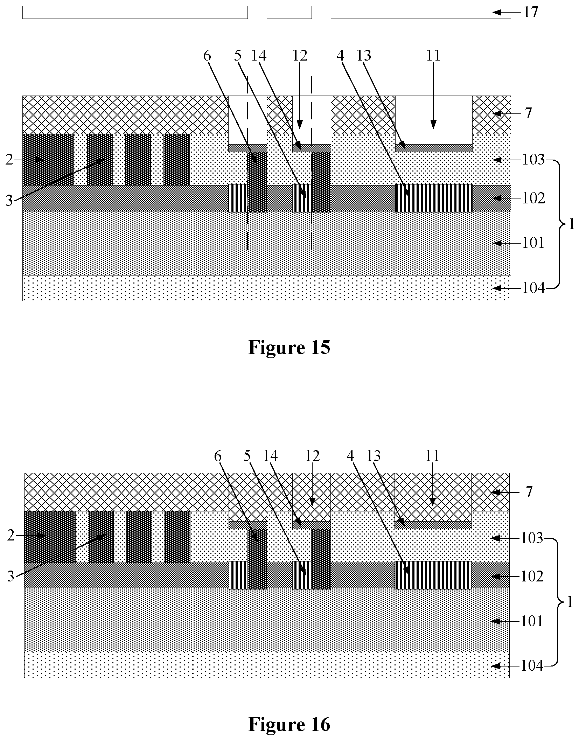

As shown in Figure 15, each second groove 12 at left of a corresponding dotted line serves as a first window, and such second groove 12 at right of the dotted line serves as a second window. The other ions are implanted via the second window(s) to form the third doped portion(s) 6. Each third doped portion 6 is in contact with the respective second protective layer 14.

In the method, step S105 is performed after the second doped portion(s) 5 and the third doped portion(s) 6 are formed. The second groove(s) 12 are filled along with the first groove 11 (as shown in Figure 16). Then, the method proceeds to step S106 to form the termination structure as shown in Figure 4.

In summary, the termination structure, the method for manufacturing the termination structure, and the power device are provided according to technical solutions of the present disclosure. Depth of ion implantation for the third doped portion(s) 6 is greater than depth of ion implantation for the FLR(s) 3, such that steps in distribution of the dopants are formed along a longitudinal direction from the cell portion 9. Such steps improve voltage tolerance of the device and decrease an area occupied by the termination structure on a chip. In addition, the termination structure is insensitive to concentration of dopants and surface charges in the JTE. Due to the buried layer 102, a strong electric field in the main-junction extension portion 2 is smoothly distributed throughout an intermediate region, namely a region of the FLR(s) 3 or a region of the FLR(s) 3 and the third doped portion(s) 6, of the termination structure. Thereby, multiple components coordinate to share energy causing avalanche breakdown, which improve an avalanche threshold of the termination structure. That is, voltage tolerance of the termination structure is improved, and hence reliability and stability of the power device are improved.

The embodiments of the present disclosure are described in a progressive manner, a parallel manner, or a combination of the progressive manner and the parallel manner. Each embodiment places emphasis on the difference from other embodiments. Therefore, one embodiment can refer to other embodiments for the same or similar parts. Since apparatuses disclosed in embodiments correspond to the method disclosed in the embodiments, the description of the apparatuses is simple, and reference may be made to the relevant part of the methods.

Herein terms indicating orientation or a positional relationship, such as "up", "low", "top", "bottom", "inner", "outer", and the like, are based on the orientation or the positional relationship as shown in the drawings. These terms are only intended for facilitating and simplifying description of the present disclosure, and do not explicitly or implicitly indicate that concerning devices or elements must have a specific orientation or must be constructed and operated based on a specific orientation. Therefore, the orientation or the positional relationship shall not be construed as a limitation on the present disclosure. In a case that a component is described to be "connected" to another component, it may be connected directly to the other component, or there may be an intermediate component between the two.

It should be noted that, the relationship terms such as "first", "second" and the like are only used herein to distinguish one entity or operation from another, rather than to necessitate or imply that an actual relationship or order exists between the entities or operations. Furthermore, the terms such as "include", "comprise" or any other variants thereof means to be non-exclusive. Therefore, a process, a method, an article or a device including a series of elements include not only the disclosed elements but also other elements that are not clearly enumerated, or further include inherent elements of the process, the method, the article or the device. Unless expressively limited, the statement "including a..." does not exclude the case that other similar elements may exist in the process, the method, the article or the device other than enumerated elements.

According to the description of the disclosed embodiments, those skilled in the art can implement or use the present disclosure. Various modifications made to these embodiments may be obvious to those skilled in the art, and the general principle defined herein may be implemented in other embodiments without departing from the spirit or scope of the present disclosure. Therefore, the present disclosure is not limited to the embodiments described herein but conforms to a widest scope in accordance with principles and novel features disclosed in the present disclosure.

## Claims

1. A termination structure, comprising:
a first epitaxial layer;
a buried layer disposed at a side of the first epitaxial layer;
a first doped portion running through the buried layer, wherein polarity of dopants in the first doped portion is opposite to polarity of dopants in the buried layer;
a second epitaxial layer disposed at a side of the buried layer away from the first epitaxial layer, wherein the second epitaxial layer comprises a main-junction extension portion and one or more field limiting rings; and
an oxide layer disposed at a side of the second epitaxial layer away from the buried layer;
wherein polarity of dopants in the second epitaxial layer and polarity of dopants in the first epitaxial layer each is opposite to the polarity of the dopants in the buried layer; and
wherein the one or more field limiting rings is disposed between the main-junction extension portion and the first doped portion along a first direction which is perpendicular to a direction pointing from the first epitaxial layer toward the second epitaxial layer.

2. The termination structure according to claim 1, wherein:
a first groove is located on a surface of the oxide layer away from the buried layer,
the first groove runs into the second epitaxial layer, and
the first groove serves as a window for ion implantation through which the first doped portion is formed.

3. The termination structure according to claim 2, further comprising:
a first protective layer disposed at a bottom of the first groove, wherein the first protective layer is separated from the first doped portion by a distance.

4. The termination structure according to claim 1, further comprising:
one or more second doped portions and one or more third doped portions, each of which runs through the buried layer, wherein:
the one or more second doped portions and the one or more third doped portions are disposed between the one or more field limiting rings and the first doped portion;
polarity of dopants in each of the one or more second doped portions is opposite to the polarity of the dopants in the buried layer;
polarity of dopants in the each of the one or more third doped portions is identical to the polarity of the dopants in the buried layer; and
concentration of the dopants in each of the one or more third doped portions is greater than concentration of the dopants in the buried layer.

5. The termination structure according to claim 4, wherein:
one or more second grooves are located at a surface of the oxide layer away from the buried layer,
the one or more second grooves runs into the second epitaxial layer, and
each of the one or more second grooves serves as a window for ion implantation through which a second doped portion of the one or more second doped portions and a third doped portion of the one or more third doped portions are formed.

6. The termination structure according to claim 5, further comprising:
a second protective layer disposed at a bottom of each of the one or more second grooves, wherein the second doped portion is separated from the second protective layer by a distance, and the third doped portions is in contact with the second protective layer.

7. The termination structure according to claim 4, wherein a quantity of the one or more third doped portions is greater than one, and the one or more third doped portions are arranged at intervals along the first direction.

8. The termination structure according to claim 5, wherein:
a distance between every adjacent ones of the one or more second grooves is identical, and respective widths of the one or more second grooves decrease gradually along a direction pointing from the main-junction extension portion toward the one or more field limiting rings; or
a width of each of the one or more second grooves is identical, and distances between adjacent ones of the one or more second grooves increase gradually along a direction pointing from the main-junction extension portion toward the one or more field limiting rings.

9. The termination structure according to claim 1, wherein a quantity of the one or more field limiting rings is greater than one, and the one or more field limiting rings are arranged at intervals along the first direction.

10. The termination structure according to claim 9, wherein:
a distance between every adjacent ones of the one or more field limiting rings is identical, and respective widths of the one or more field limiting rings decrease gradually along a direction pointing from the main-junction extension portion toward the one or more field limiting rings; or
a width of each of the one or more field limiting rings is identical, and distances between adjacent ones of the one or more field limiting rings increase gradually along a direction pointing from the main-junction extension portion toward the one or more field limiting rings.

11. A power device, comprising:
the termination structure according to any one of claims 1 to 10; and
a cell portion disposed at a side of the main-junction extension portion away from the one or more field limiting rings.

12. A method for manufacturing a termination structure, comprising:
providing an epitaxial wafer, wherein:
the epitaxial wafer comprises a first epitaxial layer, a buried layer disposed at a side of the first epitaxial layer, and a second epitaxial layer disposed at a side of the buried layer away from the first epitaxial layer, and
polarity of dopants in the second epitaxial layer and polarity of dopants in the first epitaxial layer each is opposite to polarity of dopants in the buried layer;
forming an oxide layer on a surface of the second epitaxial layer away from the buried layer;
forming a main-junction extension portion and one or more field limiting rings in the second epitaxial layer; and
forming a first doped portion running the buried layer;
wherein polarity of dopants in the first doped portion is opposite to the polarity of the dopants in the buried layer, and
wherein the one or more field limiting rings are located between the main-junction extension portion and the first doped portion along a first direction which is perpendicular to a direction pointing from the first epitaxial layer toward the second epitaxial layer.

13. The manufacturing method according to claim 12, wherein the forming the first doped portion comprises:
forming a first groove on a surface of the oxide layer away from the buried layer; and
implanting ions via the first groove to form the first doped portion.

14. The manufacturing method according to claim 13, further comprising:
forming one or more second grooves when forming the first groove;
implanting, when forming the first doped portion, the ions via the one or more second grooves to form one or more second doped portions running through the buried layer; and
implanting, after forming the one or more second doped portions, other ions via the one or more second grooves to form one or more third doped portions running through the buried layer;
wherein the one or more second doped portions and the one or more third doped portions are located between the one or more field limiting rings and the first doped portion.
